Europäisches Patentamt

(19) European Patent Office

Office européen des brevets

(11) Veröffentlichungsnummer: **0 123 062**
**B1**

(12) **EUROPÄISCHE PATENTSCHRIFT**

(45) Veröffentlichungstag der Patentschrift:
11.06.86

(51) Int. Cl.⁴: **H 01 F 40/06, G 01 R 15/02**

(21) Anmeldenummer: **84102085.2**

(22) Anmeldetag: **29.02.84**

(54) Stromteiler für Messwandler zum Messen eines Stromes.

(30) Priorität: **25.04.83 CH 2197/83**

(73) Patentinhaber: **LGZ LANDIS & GYR ZUG AG,**
**CH-6301 Zug (CH)**

(43) Veröffentlichungstag der Anmeldung:
**31.10.84 Patentblatt 84/44**

(72) Erfinder: **Halder, Mathis, Untere Rainstrasse 18,**
**CH-6340 Baar (CH)**

(45) Bekanntmachung des Hinweises auf die Patenterteilung:
**11.06.86 Patentblatt 86/24**

(84) Benannte Vertragsstaaten:
**AT DE FR GB SE**

(56) Entgegenhaltungen:
**CH - A - 537 085**
**DE - A - 2 457 797**
**DE - A - 3 008 308**
**DE - B - 2 734 729**
**US - A - 4 240 059**

## Beschreibung

Die Erfindung bezieht sich auf einen Stromteiler für Messwandler zum Messen eines Stromes der im Oberbegriff des Patentanspruchs 1 genannten Art.

Solche bekannte Stromteiler (DE-A 30 08 308) teilen den zu messenden Strom im Verhältnis der elektrischen Leitwerte der parallelen Leiter in verschiedene Teilströme auf, wobei der im Messleiter fliessende Teilstrom den Magnetkern des Messwandlers durchflutet, während die in den Nebenschlussleitern fliessenden Teilströme keinen Beitrag an die Durchflutung des Magnetkerns leisten. Gegenüber anderen bekannten Stromteilern, die z.B. auf dem Differenzprinzip (DE-B 31 40 544) oder auf dem Prinzip der elektrischen Brückenschaltung (US-A 4 240 059) beruhen, zeichnen sie sich durch eine wesentlich geringere Abhängigkeit des Stromteilerverhältnisses von den elektrischen Widerständen der verschiedenen Strompfade aus. Trotz dieses prinzipbedingten Vorteils konnten die oft sehr hohen Anforderungen an die Stabilität des Stromteilerverhältnisses bisher mit einfachen Mitteln nicht befriedigend erfüllt werden.

Der Erfindung liegt die Aufgabe zugrunde, einen einfachen, aus einem einzigen Flachleiter bestehenden Stromteiler der eingangs genannten Art zu schaffen, der sich durch eine besonders hohe Messgenauigkeit auszeichnet.

Die Lösung dieser Aufgabe gelingt durch die im Kennzeichen des Patentanspruchs 1 angegebenen Merkmale.

Nachfolgend werden einige Ausführungsbeispiele der Erfindung anhand der Zeichnung näher erläutert.

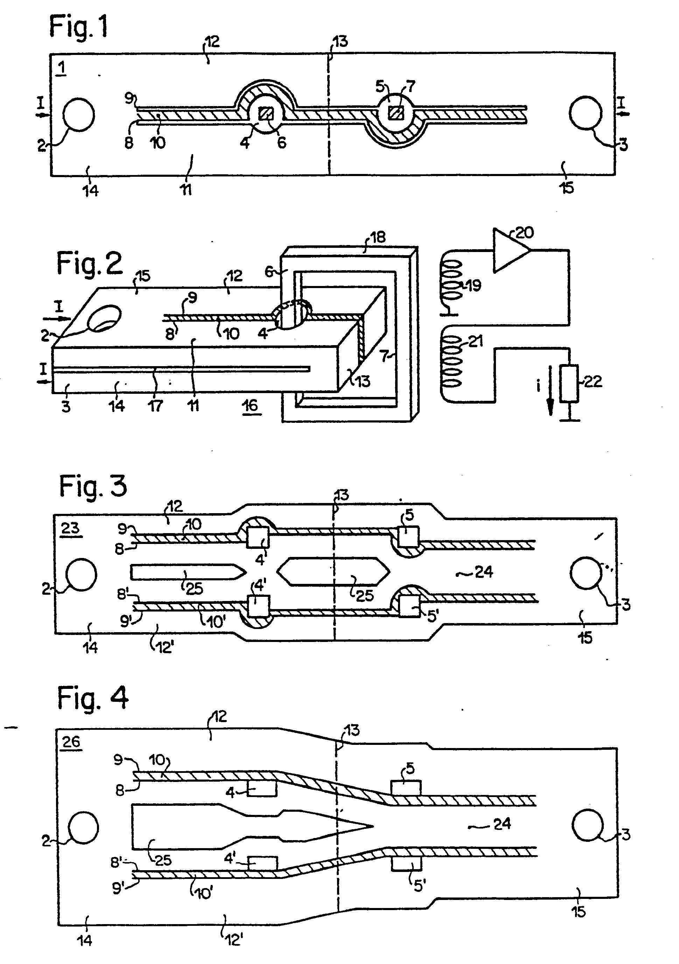

Es zeigen: Fig. 1 einen Stromteiler,
Fig. 2 einen Messwandler und
Fig. 3
und 4 weitere Stromteiler.

In der Fig. 1 bedeutet 1 einen aus einem einzigen Blechstreifen oder Metallblock bestehenden Flachleiter konstanter Dicke, der an seinen längsseitigen Enden je einen Anschluss 2 bzw. 3 aufweist. Der zu messende Strom I fliesst über den Anschluss 2 durch den Flachleiter 1 und verlässt diesen über den Anschluss 3. Der Flachleiter 1 weist zwei in seiner Längsrichtung hintereinander liegende Löcher 4, 5 auf. Ein erster Schenkel 6 eines in der Fig. 1 nicht näher dargestellten, geschlossenen Magnetkerns eines Messwandlers durchdringt das Loch 4 und ein zweiter Schenkel 7 dieses Magnetkerns durchdringt das Loch 5. Der Flachleiter 1 weist ferner zwei im wesentlichen in seiner Längsrichtung verlaufende Schlitze 8, 9 auf, die sich vorteilhaft annähernd über die gesamte Länge des Flachleiters 1 erstrecken und diesen in einen durch die Schlitze 8, 9 begrenzten Messleiter 10 sowie in zwei zum Messleiter 10 elektrisch parallele Nebenschlussleiter 11, 12 unterteilen. Zur besseren Uebersichtlichkeit ist der Messleiter 10 in der Zeichnung durch eine Schraffur zeichnerisch hervorgehoben. Der in der Zeichnung in Stromflussrichtung betrachtet rechts liegende Schlitz 8 läuft durch das Loch 4 und der links liegende Schlitz 9 läuft durch das Loch 5. In der Nähe des Loches 4 bzw. 5 ist der Schlitz 9 bzw. 8 halbkreisförmig ausgebildet und von der Lochwandung um einen Betrag distanziert, der gleich gross ist wie der gegenseitige Abstand der Schlitze 8, 9 auf ihrem geradlinigen Teil ausserhalb des Bereiches der Löcher 4, 5. Der Messleiter 10 läuft - immer in Stromflussrichtung betrachtet - auf der linken Seite halbkreisförmig um das Loch 4 herum, bewegt sich zum Loch 5, durchdringt den Magnetkern 6, 7 und läuft schliesslich auf der rechten Seite halbkreisförmig um das Loch 5 herum. Der Nebenschlussleiter 11 bzw. 12 läuft dagegen rechts bzw. links am Magnetkern 6, 7 vorbei. Für die primäre Durchflutung des Magnetkerns 6, 7 ist somit der im Messleiter 10 fliessende Teilstrom massgebend. Das Stromteilerverhältnis ist durch die elektrischen Impedanzen des Messleiters 10 und der Nebenschlussleiter 11, 12 bestimmt und somit im wesentlichen nur vom Verhältnis der Breite des Messleiters 10 zur Breite des Flachleiters 1 abhängig, da einerseits die Schlitze 8, 9 sehr schmal und andererseits die Löcher 4, 5 verhältnismässig klein sind.

Im Gegensatz zu bekannten Lösungen ist der Messleiter 10 nicht aus der Ebene des Flachleiters 1 herausgeführt. Vielmehr liegt er in der gleichen Ebene wie die Nebenschlussleiter 11, 12, ist zwischen diesen eingebettet und annähernd auf seiner ganzen Länge nur durch die Schlitze 8, 9 von den Nebenschlussleitern 11, 12 getrennt, so dass ein inniger Wärmekontakt zwischen dem Messleiter 10 und den Nebenschlussleitern 11, 12 gewährleistet ist. Einzig im Bereich des Loches 4 bzw. 5 ist die eine Seitenwand des Messleiters 10 durch das betreffende Loch vom Nebenschlussleiter 11 bzw. 12 distanziert, die andere Seitenwand ist jedoch auch in diesem Bereich nur durch den Schlitz 9 bzw. 8 vom benachbarten Nebenschlussleiter 12 bzw. 11 getrennt, so dass ein nahezu ideales Temperaturausgleich und damit eine von der Stärke des zu messenden Stromes I unabhängige Stromverteilung im Flachleiter 1 gewährleistet ist und eine sehr hohe Messgenauigkeit erzielt wird.

Vorteilhaft ist die Breite der Schlitze 8, 9 im Vergleich zur Dicke des Flachleiters 1 klein, so dass sich eine optimale Wärmekopplung zwischen dem Messleiter 10 und den Nebenschlussleitern 11, 12 ergibt. Die Länge des Messleiters 10 ist vorteilhaft gross im Vergleich zur Dicke der Löcher 4, 5, wodurch erreicht wird, dass jener Teilbereich des Messleiters 10, in welchem die isothermischen Bedingungen nicht vollkommen erfüllt sind, vernachlässigbar klein ist.

Zur Herstellung der Schlitze 8, 9 eignen sich spanabhebende und spanlose Bearbeitungsverfahren. Besonders schmale Schlitze lassen sich mit Hilfe eines Laserstrahls erzeugen. In die Schlitze 8, 9 kann eine elektrisch isolierende, thermisch leitende Schicht eingefügt werden.

Vorteilhaft weist der Flachleiter 1 die Form eines U auf. Dies lässt sich dadurch erreichen, dass der Flachleiter 1 entlang einer Biegekante bzw. Umkehrkante 13 in seiner auerrichtung gefaltet, d.h. um 180° umgeklappt wird, so dass die beiden Löcher 4, 5 deckungsgleich übereinander zu liegen kommen und die beiden Schenkel 14, 15 des Flachleiters 1 - durch eine dünne Isolierschicht voneinander getrennt - miteinander in engem thermischem Kontakt stehen. Dabei werden optim ale thermische Verhältnisse erzielt, wenn die Breite der Schlitze 8, 9 klein ist im Vergleich zum Abstand der beiden Schenkel 14, 15.

Die Form des U-förmig gefalteten Flachleiters kann auch unmittelbar aus einem Gussteil oder Strangpressteil herausgearbeitet sein. Die Fig. 2 zeigt ein Beispiel eines so hergestellten Flachleiters 16, bei dem gleiche bzw. gleich wirkende Teile wie in der Fig. 1 mit den gleichen Bezugszahlen bezeichnet sind. Die Schlitze 8, 9 sind in der Fig. 2 aus Gründen der zeichnerischen Klarheit durch einfache ausgezogene Linien dargestellt. Als Isolationsschicht 17 zwischen den Schenkeln 14, 15 eignet sich vorteilhaft ein beidseitig eloxiertes Aluminiumblech. Der Schenkel 6 des Magnetkerns 18 durchdringt sowohl das Loch 4 als auch das in der Fig. 2 nicht sichtbare Loch 5, während der Schenkel 7 den Magnetkreis ausserhalb des Flachleiters 1 schliesst.

Im dargestellten Beispiel arbeitet der beschriebene M esswandler als sogenannter aktiver Stromwandler. Dazu ist eine auf dem Magnetkern 18 angeordnete Detektorwicklung 19 mit dem Eingang eines Verstärkers 20 verbunden, dessen Ausgang an eine aus einer Sekundärwicklung 21 und einer Bürde 22 bestehende Reihenschaltung angeschlossen ist.

Der Flachleiter 16 stellt die Primärwicklung des Messwandlers dar. Für die primäre Durchflutung ist der im Messleiter 10 fliessende Teilstrom massgebend. Die Kompensation der primären Durchflutung erfolgt in bekannter Weise durch einen in der Sekundärwicklung 21 fliessenden Strom i, der in einem Regelkreis vom Verstärker 20 so gesteuert wird, dass die in der Detektorwicklung 19 induzierte Spannung gegen Null geht.

Durch die von der Stärke des zu messenden Stromes I unabhängige Stromverteilung im Flachleiter 16 wird eine sehr hohe Messgenauigkeit erzielt. Da sich sowohl die Nebenschlussleiter 11, 12 als auch der Messleiter 10 in entgegengesetzter Stromflussrichtung über die beiden Schenkel 14, 15 erstrecken, ergibt sich eine weitgehend induktionsfreie Anordnung, eine nur geringe Streufelderzeugung und damit auch ein nur sehr kleiner Phasenfehler.

Die Detektorwicklung 19 kann entfallen, wenn an ihrer Stelle ein Magnetfeldsensor, der z.B. das Magnetfeld in einem Luftspalt des Magnetkerns 18 erfasst an den Eingang des Verstärkers 20 angeschlossen wird.

Der beschriebene Messwandler kann auch als sogenannter zeitverschlüsselter Wandler gemäss der Lehre der CH-A 618 043 betrie ben werden. Dabei entfallen die Teile 19 bis 22, der primären Durchflutung des Magnetkerns 18 wird mittels einer Vormagnetisierungswicklung eine alternierende Referenzdurchflutung überlagert und mit Hilfe eines in einem Luftspalt des Magnetkerns 18 angeordneten Magnetfeldsensors werden die Zeitpunkte der Nulldurchgänge des resultierenden Mangetfeldes erfasst.

Der U-förmige Flachleiter 1 bzw. 16 ist ohne weiteres bei einem Messwandler mit dreischenkligem Magnetkern verwendbar. Zur Verwendung als Primärwicklung in einem topfförmigen Magnetkern ist allenfalls eine Anpassung der Form der Aussenkonturen des Flachleiters 16 erforderlich.

Der Flachleiter 23 nach der Fig. 3 weist ausser den beiden Löchern 4, 5 und den beiden Schlitzen 8, 9 zwei weitere Löcher 4', 5' und zwei weitere Schlitze 8', 9' auf. Die Löcher 4 und 4', die Löcher 5 und 5', die Schlitze 8 und 8' sowie die Schlitze 9 und 9' sind zur Längsache des Flachleiters 23 spiegelsymmentisch angeordnet. Die Schlitze 8, 9 und 8', 9' unterteilen den Flachleiter 23 in zwei äussere Nebenschlussleiter 12 und 12' und einen mittleren Nebenschlussleiter 24 sowie in zwei Messleiter 10 und 10', wobei der Messleiter 10 zwischen den Nebenschlussleitern 12 und 24 und der Messleiter 10' zwischen den Nebenschlussleitern 12' und 24 eingebettet isti Nach dem Falten des Flachleiters 23 um die Biegekante 13 liegt einerseits das Loch 5 deckungsgleich über dem Loch 4 und anderseits das Loch 5' deckungsgleich über dem Loch 4'. Die Löcher 4, 5 sind zur Aufnahme des Schenkels 6 des Magnetkerns 18 (Fig. 2) und die Löcher 4' 5' zur Aufnahme des Schenkels 7 bestimmt. Für die primäre Durchflutung des Magnetkerns 10 ist die Summe der in den beiden Messleitern 10, 10' fliessenden Teilströme massgebend.

Es ist leicht einzusehen, dass beim Flachleiter 23 die gleichen vorteilhaften Wirkungen eintreten wie beim Flachleiter 1 bzw. 16. Da beide Schenkel 6, 7 des Magnetkerns 18 den Flachleiter 23 durchdringen, ergibt sich zudem eine weitestgehend symmetrische Anordnung und damit eine hohe Unempfindlichkeit gegen äussere Störfeldeinflüsse.

Der mittlere Nebenschlussleiter 24 des Flachleiters 23 weist Aussparungen 25 auf die derart geformt sind, dass die Querschnittsfläche des Nebenschlussleiters 24 über seiner ganzen Länge annähernd konstant ist, so dass eine konstante Stromdichte und damit eine gleichmässige Erwärmung erreicht wird. Zum gleichen Zweck ist die Breite des Flachleiters 23 unterschiedlich.

Beim Flachleiter 26 nach der Fig. 4 sind die Schlitze 8, 9 und 8', 9' derart geformt, dass die Messleiter 10, 10' jedrei gerade Leiterteile bilden, wobei die dem Schenkel 14 angehörenden Hälften der Messleiter 10, 10' weiter aussen liegen als die dem Schenkei 15 angehörende Hälften. Dies führt nach dem Falten des Flachleiters 26 zu einer optimalen Ueberdeckung der einzelnen Leiterteile, d.h. die dem einen Schenkel 14 bzw. 15 angehörenden Teile der Nebenschlussleiter 12, 12' und 24 überdecken die dem anderen Schenkel 15 bzw..14 angehörenden Teile der Messleiter 10 und 10'.

## Patentansprüche

1. Stromteiler für Messwandler zum Messen eines Stromes, mit einem Flachleiter (1; 16; 23; 26), der mindestens zwei im wesentlichen Längsrichtung des Flachleiters angeordnete Schlize (8, 9, 8', 9') aufweist, die den Flachleiter in mindestens einen Messleiter (10, 10') und in mindestens zwei zu diesem elektrisch parallele Nebenschlussleiter (11; 12; 12'; 24) unterteilen, wobei der Messleiter einen Magnetkern (18) des Messwandlers durchdringt, dadurch gekennzeichnet, dass der Flachleiter 16; 23; 26) zwei in seiner Längsrichtung hintereinander liegende Löcher (4; 5 bzw. 4'; 5') aufweist, durch die der Magnetkern (18) hindurchgeführt ist, dass der eine Schlitz (8 bzw. 8') durch das eine Loch (4 bzw. 4') und der andere Schlitz (9 bzw. 9') durch das andere Loch (5 bzw. 5') läuft und dass der Messleiter (10 bzw. 10') inder gleichen Ebene liegt wie die Nebenschlussleiter (11; 12; 12'; 24) und zwischen diesen eingebettet ist.

2. Stromteiler nach Anspruch 1, dadurch gekennzeichnet, dass der Flachleiter (1; 16; 23; 26) die Form eines U aufweist, dass die beiden Löcher (4; 5 bzw. 4'; 5') deckungsgleich übereinander liegen und dass die beiden Schenkel (14; 15) des Flachleiters (1; 16; 23; 26) elektrisch voneinander isoliert sind und miteinander in engem thermischen Kontakt stehen.

3. Stromteiler nach Anspruch 1 oder 2, dadurch gekennzeichnet, dass die Breite der Schlitze (8; 8'; 9; 9') klein ist im Vergleich zur Dicke des Flachleiters (1; 16; 23; 26).

4. Stromteiler nach Anspruch 2, dadurch gekennzeichnet, dass die Breite der Schlitze (8; 8'; 9; 9') klein ist im Vergleich zum Abstand der beiden Schenkel (14; 15) des Flachleiters (1; 16; 23; 26).

5. Stromteiler nach einem der Ansprüche 1 bis 4, dadurch gekennzeichnet, dass die Länge des Messleiters (10; 10') gross ist im Vergleich zur Dicke der Löcher (4; 4'; 5; 5').

6. Stromteiler nach einem der Ansprüche 2 bis 5, dadurch gekennzeichnet, dass der Flachleiter (23; 26) vier Schlitze (8; 8'; 9; 9') aufweist, die den Flachleiter (23; 26) in zwei äussere Nebenschlussleiter (12; 12') und einem mittleren Nebenschlussleiter (24) sowie in zwei Messleiter (10; 10') unterteilen, wobei jeder der Messleiter (10; 10') zwischen einem der äusseren Nebenschlussleiter (12; 12') und dem mittleren Nebenschlussleiter (24) eingebettet ist.

7. Stromteiler nach einem der Ansprüche 1 bis 6, dadurch gekennzeichnets dass der Flachleiter (1; 16; 23; 26) Aussparungen (25) aufweist und/oder seine Breite unterschiedlich ist, derart, dass die Stromdichte in den Nebenschlussleitern (11; 12; 12'; 24) konstant ist.

8. Stromteiler nach Anspruch 6 oder 7, dadurch gekennzeichnet, dass jeweils die dem einen Schenkel (14 bzw. 15) des Flachleiters (1; 16; 23; 26) angehörenden Teile der Nebenschlussleiter (11; 12; 12'; 24) die dem anderen Schenkel (15 bzw. 14) des Flachleiters (1; 16; 23; 26) angehörenden Teile der Messleiter (10, 10') im wesentlichen überdecken.

## Claims

1. A current divider for a measuring transducer for measuring a current comprising a flat conductor (1; 16; 23; 26) which has at least two slots (8, 9, 8', 9') which are disposed substantially in the longitudinal direction of the flat conductor and which subdivide the flat conductor into at least one measuring conductor (10, 10') and at least two shunt conductors (11; 12; 12'; 24) which are electrically parallel to the measuring conductor, wherein the measuring conductor passes through a magnetic core (18) of the measuring transformer, characterised in that the flat conductor (1; 16; 23; 26) has two holes (4; 5 and 4'; 5' respectively) which are disposed one behind the other in its longitudinal direction and through which the magnetic core (18) is passed, that the one slot (8 or 8') passes through the one hole (4 or 4') and the other slot (9 or 9') passes through the other hole (5 or 5') and that the measuring conductor (10 or 10') is disposed in the same plane as the shunt conductors (11; 12; 12'; 24) and is embedded between them.

2. A current divider according to claim 1 characterised in that the flat conductor (1; 16; 23; 26) is in the form of a U, that the two holes (4; 5 and 4'; 5') are disposed in mutual alignment one above the other and that the two limbs (14; 15) of the flat conductor (1; 16; 23; 26) are electrically insulated from each other and are in close thermal contact with each other.

3. A current divider according to claim 1 or claim 2 characterised in that the width of the slots (8; 8'; 9; 9') is small in comparison with the thickness of the flat conductor (l; 16; 23; 26).

4. A current divider according to claim 2 characterised in that the width of the slots (8; 8'; 9; 9') is small in comparison with the spacing of the two limbs (14; 15) of the flat conductor (1; 16; 23; 26).

5. A current divider according to one of claims 1 to 4 characterised in that the length of the measuring conductor (10; 10') is large in comparison with the thickness of the holes (4; 4'; 5; 5').

6. A current divider according to one of claims 2 to 5 characterised in that the flat conductor (23; 26) has four slots (8; 8'; 9; 9') which subdivide the flat conductor (23; 26) into two outer shunt conductors (12; 12') and a middle shunt conductor (24) and into two measuring conductors (10; 10'), wherein each of the measuring conductors (10; 10') is embedded between one of the outer shunt conductors (12; 12') and the middle shunt conductor (24).

7. A current divider according to one of claims 1 to 6 characterised in that the flat conductor (I; 16; 23; 26) has openings (25) and/or its width is different in such a way that the current density in the shunt conductors (11; 12; 12'; 24) is constant.

8. A current divider according to claim 6 or claim 7 characterised in that the respective parts of the shunt conductors (11; 12; 12'; 24), which are associated with the one limb (14 or 15) of the flat conductor (I; 16; 23; 26) substantially overlap the parts of the measuring conductors (10, 10'), which are associated with the other limb (15 or 14) of the flat conductor (1; 16; 23; 26).

## Revendications

1. Diviseur de courant pour un transformateur de mesure destiné à mesurer un courant, comprenant un conducteur plat (1; 16; 23; 26), qui comporte au moins deux fentes (8, 9; 9') disposées essentiellement suivant la direction longitudinale du conducteur plat et qui subdivisent le conducteur plat en au moins un conducteur de mesure (10, 10') et en au moins deux conducteurs de dérivation (11; 12; 12'; 24) en parallèle du point de vue électrique, le conducteur de mesure traversant un noyau magnétique (18) du transformateur de mesure, caractérisé par le fait que le conducteur plat (I; 16; 23; 26) possède deux trous (4; 5 ou 4'; 5') situés l'un derrière l'autre suivant la direction longitudinale et que traverse le noyau magnétique (18), qu'une fente (8 ou 8') passe par un trou (4 ou 4') et que l'autre fente (9 ou 9') passe par l'autre trou (5 ou 5'), et que le conducteur de mesure (10 ou 10') est situé dans le même plan que les conducteurs de dérivation (11 12; 12'; 24) et est inséré entre ces derniers.

2. Diviseur de courant suivant la revendication 1, caractérisé par le fait que le conducteur plat (1; 16; 23; 26) possède la forme d'un U, que les deux trous (4; 5 ou 4'; 5') sont situés en étant alignés l'un au-dessus de l'autre et que les deux branches (14; 15) du conducteur plat (I; 16; 23; 26) sont isolées électriquement l'une de l'autre et établissent entre elles un étroit contact thermique.

3. Diviseur de courant suivant la revendication I ou 2, caractérisé par le fait que la largeur des fentes (8; 8'; 9; 9') est faible par rapport à l'épaisseur du conducteur plat (1; 16; 23; 26).

4. Diviseur de courant selon la revendication 2, caractérisé par le fait que la largeur des fentes (8; 8'; 9 9') est faible par rapport à la distance des deux branches (14; 15) du conducteur plat (I; 16; 23; 26).

5. Diviseur de courant suivant l'une des revendications 1 à 4, caractérisé par le fait que la longueur du conducteur de mesure (10; 10') est importante par rapport à la largeur des trous (4; 4'; 5; 5').

6. Diviseur de courant suivant l'une des revendications 2 à 5, caractérisé par le fait que le conducteur plat (23; 26) possède quatre fentes (8; 8'; 9; 9') qui subdivisent le conducteur plat (23; 26) en deux conducteurs extérieurs de dérivation (12; 12') et en un conducteur central de dérivation (24) ainsi qu'en deux conducteurs de mesure (10; 10'), chacun des conducteurs de mesure (10; 10') étant inséré entre l'un des conducteurs extérieurs de dérivation (12; 12') et le conducteur médian de dérivation (24).

7. Diviseur de courant selon l'une des revendications 1 à 6, caractérisé par le fait que le conducteur plat (I; 16; 23; 26) comporte des évidements (25) et/ou que sa largeur est variable de telle sorte que la densité de courant est constante dans les conducteurs de dérivation (11; 12; 12'; 24).

8. Diviseur de courant selon la revendication 6 ou 7, caractérisé par le fait que les parties respectives des conducteurs de dérivation (II; 12; 12'; 24), qui appartiennent à une branche (14 ou 15) du conducteur plat (1; 16; 23; 26), recouvrent essentiellement les parties des conducteurs de mesure (10; 10'), qui appartiennent à l'autre branche (15 ou 14) du conducteur plat (1; 16; 23; 26).

0 123 062

Fig.1

Fig.2

Fig. 3

Fig. 4

1